# EUROPEAN PATENT APPLICATION

(11) **EP 4 697 920 A1**
(43) Date of publication of application: **18.02.2026**
(21) Application number: 25186804.8
(22) Date of filing: 01.07.2025
(51) Int. Cl.: H10N 60/01, H10N 69/00, H10W 20/20

(54) **METHOD OF MANUFACTURING DEVICE AND DEVICE**

(30) Priority: 07.08.2024 JP 2024131066
(71) Applicant: FUJITSU LIMITED, Kawasaki-shi, Kanagawa 211-8588 (JP)
(72) Inventor: NAKAMURA, Makoto, Kawasaki-shi, 211-8588 (JP)
(74) Representative: Haseltine Lake Kempner LLP

(57) **Abstract**

A method of manufacturing a device (100, 200, 300, 400, 410, 500, 510) includes forming a conductive film (61) on a second surface (12) of a substrate (10) having a first surface (11) and the second surface opposite to the first surface by using a non-superconducting material, forming a through hole (13) penetrating the substrate by etching the substrate from the first surface after forming the conductive film, forming a through electrode (30) in the through hole by using a superconducting material by an electroplating method using the conductive film exposed in the through hole as a seed layer, and removing the conductive film after forming the through electrode.

## Description

### FIELD

A certain aspect of the present embodiments relates to a method of manufacturing a device and a device.

### BACKGROUND

There has been known a device in which a through electrode penetrating a substrate between a first surface and a second surface is provided in order to conduct a circuit provided on the first surface and the second surface of the substrate. It is known to from such a through electrode by injection molding (for example, U.S. Patent Application Publication No. 2018/0005887). It is also known to form a through electrode by an electroplating method (for example, International Publication Pamphlet No. WO 2023/085366, Japanese National Publication of International Patent Application No. 2020-522128, and U.S. Patent Application Publication No. 2022/0359415).

### SUMMARY

When the through electrode of the superconducting material is formed by the electroplating method, a conductive film of a non-superconducting material is sometimes used as a seed layer. In this case, since a part of the through electrode is formed of the non-superconducting material, the electrical resistance of the through electrode increases even at a low temperature, and the characteristics may deteriorate.

In one aspect, the object is to suppress the deterioration of characteristics.

According to an aspect of the present disclosure, there is provided a method of manufacturing a device including forming a conductive film on a second surface of a substrate having a first surface and the second surface opposite to the first surface by using a non-superconducting material, forming a through hole penetrating the substrate by etching the substrate from the first surface after forming the conductive film, forming a through electrode in the through hole by using a superconducting material by an electroplating method using the conductive film exposed in the through hole as a seed layer, and removing the conductive film after forming the through electrode.

### BRIEF DESCRIPTION OF THE DRAWINGS

FIG. 1 is a cross-sectional view of a device according to a first embodiment.
FIGs. 2A to 2C are cross-sectional views (part 1) illustrating a method of manufacturing a device according to the first embodiment.
FIGs. 3A to 3C are cross-sectional views (part 2) illustrating a method of manufacturing a device according to the first embodiment.
FIGs. 4A and 4B are cross-sectional views (part 3) illustrating a method of manufacturing a device according to the first embodiment.
FIGs. 5A to 5C are cross-sectional views (part 1) illustrating a method of manufacturing a device according to a comparative example.
FIGs. 6A to 6C are cross-sectional views (part 2) illustrating a method of manufacturing a device according to the comparative example.
FIG. 7A is a cross-sectional view of a device according to a second embodiment, and FIG. 7B is a plan view of the vicinity of a through electrode in the second embodiment as viewed from a -Z direction.
FIGs. 8A to 8C are cross-sectional views (part 1) illustrating a method of manufacturing a device according to the second embodiment.
FIGs. 9A to 9C are cross-sectional views (part 2) illustrating a method of manufacturing a device according to the second embodiment.
FIG. 10A is a cross-sectional view of a device according to a third embodiment, and FIG. 10B is a plan view of the vicinity of a through electrode in the third embodiment as viewed from the -Z direction.
FIGs. 11A to 11C are cross-sectional views illustrating a method of manufacturing a device according to the third embodiment.
FIG. 12 is a cross-sectional view of a device according to a fourth embodiment.
FIGs. 13A and 13B are cross-sectional views illustrating a method of manufacturing a device according to the fourth embodiment.
FIG. 14 is a cross-sectional view of a device according to a modification of the fourth embodiment.
FIG. 15 is a cross-sectional view of a device according to a fifth embodiment.
FIG. 16 is a cross-sectional view of a device according to a modification of the fifth embodiment.

### EFFECT

As one aspect, it is possible to suppress the deterioration of characteristics.

### DETAILED DESCRIPTION

Embodiments of the present disclosure will be described below with reference to the drawings. In the first to third embodiments, an example of an interposer will be described. In the fourth and fifth embodiments, examples of a qubit device will be described.

### [First Embodiment]

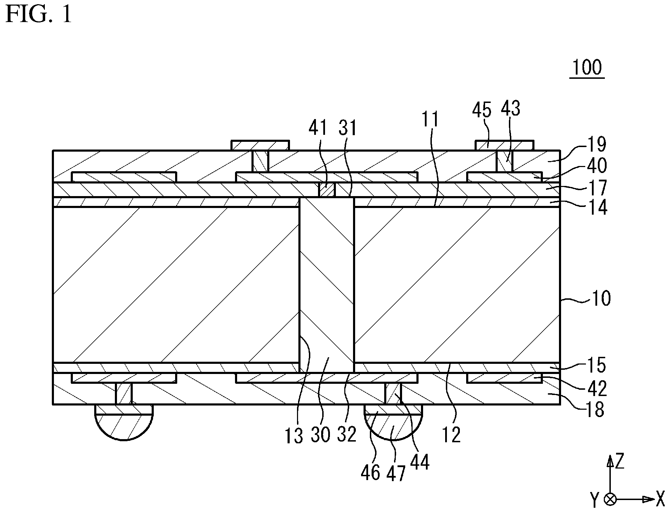

FIG. 1 is a cross-sectional view of a device 100 according to a first embodiment. The directions parallel to an upper surface 11 of a substrate 10 and perpendicular to each other are referred to as an X-axis direction and a Y-axis direction. The thickness direction of the substrate 10 is defined as a Z-axis direction. As illustrated in FIG. 1, a through hole 13 penetrating from the upper surface 11 to a lower surface 12 is provided in the substrate 10 having the upper surface 11 and the lower surface 12. The substrate 10 is, for example, a silicon (Si) substrate. The thickness of the substrate 10 is, for example, 300 µm to 500 µm. The diameter of the through hole 13 is, for example, 50 µm to 100 µm.

An insulating film 14 is provided on the upper surface 11 of the substrate 10. An insulating film 15 is provided on the lower surface 12 of the substrate 10. A through electrode 30 is provided in the through hole 13. The through electrode 30 is completely embedded in the through hole 13. An upper surface 31 of the through electrode 30 is substantially flush with an upper surface of the insulating film 14. A lower surface 32 of the through electrode 30 is substantially flush with a lower surface of the insulating film 15. The insulating film 14 and the insulating film 15 are, for example, silicon oxide (SiO₂) films. The thicknesses of the insulating film 14 and the insulating film 15 are, for example, 50 nm to 100 nm. The through electrode 30 is formed of a superconducting material that exhibits superconductivity at a temperature of a predetermined temperature or lower (for example, 10K or lower). The through electrode 30 is formed of, for example, tin (Sn).

An insulating film 17 is provided on the insulating film 14 and the through electrode 30. Wirings 40 are provided on the insulating film 17. The wiring 40 is connected to the through electrode 30 by a via wiring 41 penetrating the insulating film 17. An insulating film 19 is provided on the insulating film 17 to cover the wirings 40. Terminal electrodes 45 are provided on the insulating film 19. The terminal electrodes 45 are connected to the wirings 40 by via wirings 43 penetrating the insulating film 19. The insulating film 17 and the insulating film 19 are, for example, silicon oxide (SiO₂) films. The thicknesses of the insulating film 17 and the insulating film 19 are, for example, 100 nm to 300 nm. The wirings 40, the via wiring 41, the via wirings 43, and the terminal electrodes 45 are formed of a superconducting material. The wirings 40, the via wiring 41, the via wirings 43, and the terminal electrodes 45 are formed of, for example, titanium nitride (TiN). The thicknesses of the wirings 40 and the terminal electrode 45 are, for example, 50 nm to 150 nm.

Wirings 42 are provided on the insulating film 15 and the through electrode 30. At least a part of the wirings 42 is connected to the through electrode 30 by being in contact with the lower surface 32 of the through electrode 30. An insulating film 18 is provided on the insulating film 15 to cover the wirings 42. Terminal electrodes 46 are provided on the insulating film 18. The terminal electrodes 46 are connected to the wirings 42 by via wirings 44 penetrating the insulating film 18. Bump electrodes 47 are provided on the terminal electrodes 46. The insulating film 18 is, for example, a silicon oxide (SiO₂) film. The thickness of the insulating film 18 is, for example, 100 nm to 300 nm. The wirings 42, the via wirings 44, and the terminal electrodes 46 are formed of a superconducting material. The wiring 42, the via wirings 44, and the terminal electrodes 46 are formed of, for example, titanium nitride (TiN). The thicknesses of the wirings 42 and the terminal electrodes 46 are, for example, 50 nm to 150 nm. The bump electrodes 47 are formed of a superconducting material. The bump electrodes 47 are formed of, for example, indium (In).

The substrate 10 is not limited to a silicon substrate, and may be a glass substrate, a quartz substrate, a sapphire substrate, an alumina substrate, a silicon carbide substrate, or the like. When the substrate 10 is formed of an inorganic material having an insulating property, the insulating film 14 and the insulating film 15 need not be provided. The through electrode 30 may be formed of a superconducting material such as zinc (Zn), cadmium (Cd), lead (Pb), indium (In), or ruthenium (Ru), in addition to tin (Sn). The insulating films 14, 15, 17, 18 and 19 are not limited to the silicon oxide film, and may be a silicon nitride film, an aluminum oxide film, an aluminum nitride film, or the like. The wirings 40, the via wiring 41, the wirings 42, the via wirings 43, the via wirings 44, the terminal electrodes 45, and the terminal electrodes 46 may be formed of the superconducting material other than titanium nitride (TiN). For example, the insulating film may be formed of aluminum (Al), vanadium (V), niobium (Nb), tantalum (Ta), vanadium nitride (VN), niobium nitride (NbN), or tantalum nitride (TaN).

### [Manufacturing Method]

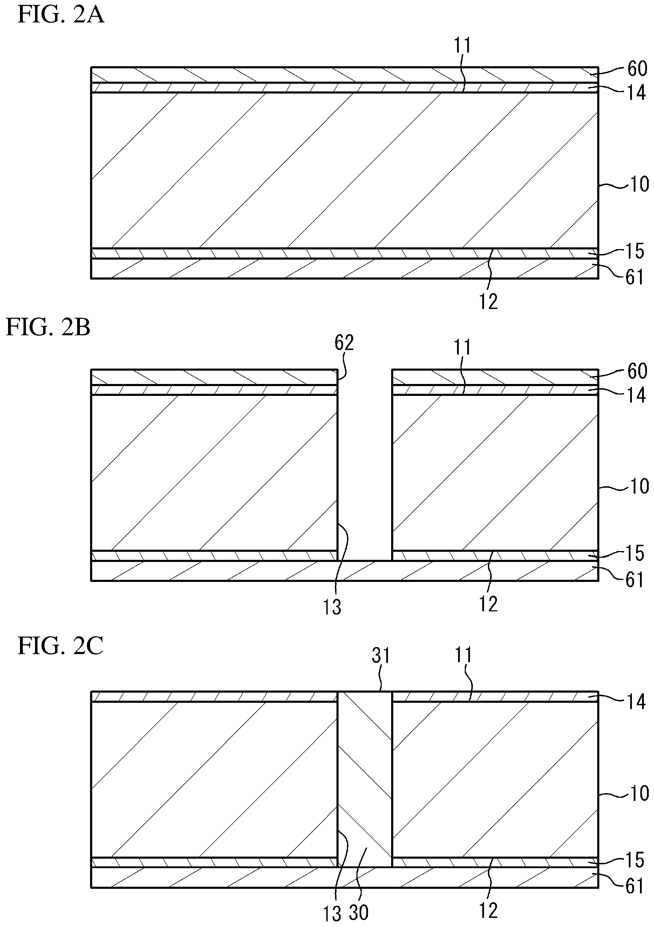

FIGs. 2A to 4B are cross-sectional views illustrating a method of manufacturing the device 100 according to the first embodiment. As illustrated in FIG. 2A, the substrate 10, which is a silicon substrate having a thickness of, for example, 300 µm to 400 µm, is heated in an oxygen atmosphere to form the insulating film 14 and the insulating film 15, which are silicon oxide films, on the upper surface 11 and the lower surface 12. The thicknesses of the insulating film 14 and the insulating film 15 are, for example, 100 nm. Thereafter, a metal mask layer 60 is formed on the insulating film 14. The metal mask layer 60 is, for example, an aluminum (Al) layer and is formed by a sputtering method. The thickness of the metal mask layer 60 is, for example, 500 nm. A conductive film 61 is formed on the insulating film 15. The conductive film 61 is, for example, a copper (Cu) film. The conductive film 61 is formed by forming a Cu film having a thickness of about 100 nm by, for example, the sputtering method and then forming a Cu film having a thickness of about 1 µm to 2 µm by an electroplating method. An adhesive layer such as a titanium (Ti) layer may be formed between the insulating film 15 and the conductive film 61. The thickness of the adhesive layer may be 20 nm, for example. Either the metal mask layer 60 or the conductive film 61 may be formed first.

As illustrated in FIG. 2B, the metal mask layer 60 and the insulating film 14 are etched using a resist mask layer (not illustrated) formed on the metal mask layer 60 as a mask, and an opening 62 is formed in the metal mask layer 60 and the insulating film 14. The metal mask layer 60 and the insulating film 14 are etched by, for example, a reactive ion etching (RIE) method. Next, the substrate 10 is etched using the metal mask layer 60 as a mask, and the through hole 13 penetrating the substrate 10 from the upper surface 11 to the lower surface 12 is formed. The through hole 13 is formed by, for example, a deep reactive ion etching (Deep-RIE) method using a Bosch process. The diameter of the through hole 13 is, for example, 50 µm to 100 µm. Next, the insulating film 15 exposed on the bottom surface of the through hole 13 is removed by, for example, the reactive ion etching method. As a result, the conductive film 61 is exposed in the through hole 13.

As illustrated in FIG. 2C, the metal mask layer 60 is removed by, for example, a wet etching method. Thereafter, a superconducting film is embedded in the through hole 13 by the electroplating method using the conductive film 61 as a seed layer, and the through electrode 30 made of a superconducting film is formed. The through electrode 30 made of, for example, tin (Sn) is formed. The upper surface 31 of the through electrode 30 is made to be substantially flush with the upper surface of the insulating film 14.

The reason why Cu, which is the non-superconducting material, is used for the conductive film 61 to be a seed layer is as follows. The first reason is that Cu, which is the non-superconducting material, has a large electrical conductivity. The second reason is that Cu, which is the non-superconducting material, has a small ionization tendency and is therefore less likely to be eluted into the plating solution. A third reason is that Cu, which is the non-superconducting material, can be formed into a film by plating and can be easily thickened. The third reason is that Cu, which is the non-superconducting material, can be formed into a film by a plating method and can be easily formed into a thick film. The fourth reason is that Cu, which is the non-superconducting material, can be easily removed by the wet etching method or a chemical mechanical polishing (CMP) method. For these reasons, Cu, which is a non-superconductive material, is used for the conductive film 61 to be a seed layer.

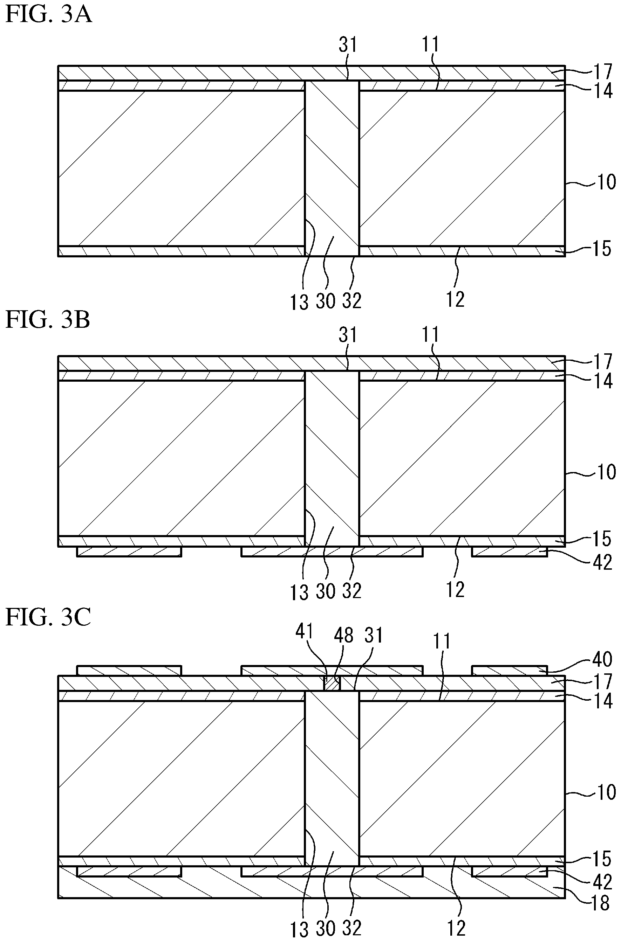

As illustrated in FIG. 3A, the insulating film 17 is formed on the insulating film 14 so as to cover the upper surface 31 of the through electrode 30. The insulating film 17 is formed by using, for example, a chemical vapor deposition (CVD) method. The insulating film 17 is, for example, a silicon oxide film, and has a thickness of 200 nm, for example. Thereafter, the conductive film 61 is removed by the wet etching method or the CMP method. Thus, the lower surface 32 of the through electrode 30 and the lower surface of the insulating film 15 are substantially flush with each other. The insulating film 17 is provided to protect the through electrode 30 in the step of removing the conductive film 61.

As illustrated in FIG. 3B, a superconducting film is formed on the insulating film 15 by, for example, the sputtering method, and then the superconducting film is patterned by, for example, the reactive ion etching method, thereby forming the wirings 42 on the insulating film 15. At least a part of the wirings 42 is connected to the through electrode 30 by being in contact with the lower surface 32 of the through electrode 30. The wirings 42 are formed of, for example, titanium nitride (TiN). The thickness of the wiring 42 is, for example, 100 nm. In this way, the through electrode 30 and the wirings 42 are formed of different superconducting materials.

As illustrated in FIG. 3C, the insulating film 18 is formed on the insulating film 15 so as to cover the wirings 42. The insulating film 18 is formed by, for example, the CVD method. The insulating film 18 is, for example, a silicon oxide film and has a thickness of 200 nm, for example. A through hole 48 reaching the through electrode 30 is formed in the insulating film 17 by using, for example, the reactive ion etching method. The via wiring 41 connected to the through electrode 30 is formed in the through hole 48. The wirings 40 are formed on the insulating film 17. The via wiring 41 and the wirings 40 are formed by using, for example, the sputtering method and the etching method. The via wiring 41 and the wirings 40 are formed of, for example, titanium nitride (TiN). The thicknesses of the wirings 40 are, for example, 100 nm.

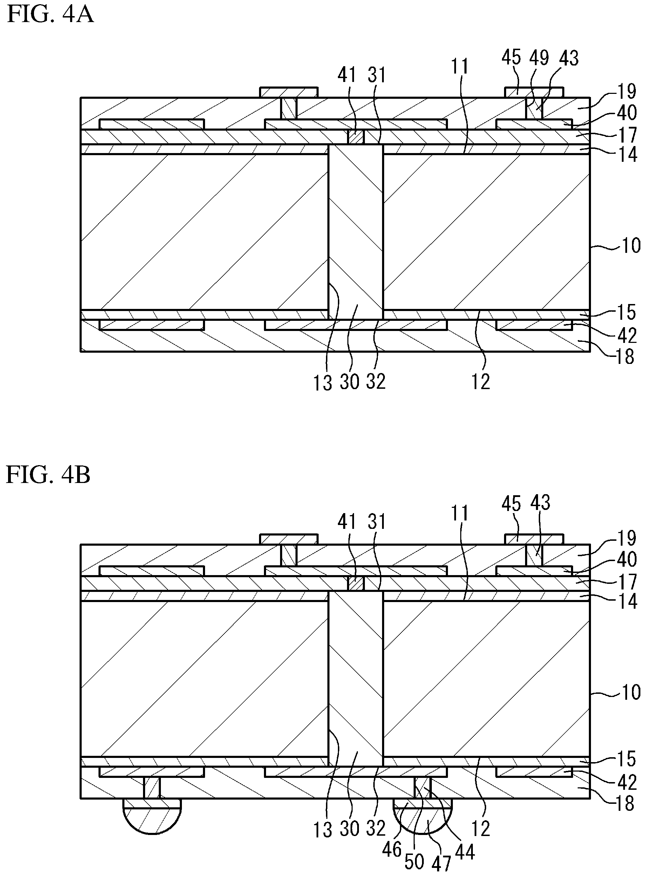

As illustrated in FIG. 4A, the insulating film 19 is formed on the insulating film 17 so as to cover the wiring 40. The insulating film 19 is formed by, for example, the CVD method. The insulating film 19 is, for example, a silicon oxide film and has a thickness of 200 nm, for example. Then, through holes 49 reaching the wirings 40 are formed in the insulating film 19 by using, for example, the reactive ion etching method. The via wirings 43 connected to the wirings 40 are formed in the through holes 49. The terminal electrodes 45 connected to the via wirings 43 are formed on the insulating film 19. The via wirings 43 and the terminal electrodes 45 are formed by using, for example, the sputtering method and the etching method. The via wirings 43 and the terminal electrodes 45 are formed of titanium nitride (TiN), for example.

As illustrated in FIG. 4B, through holes 50 reaching the wirings 42 are formed in the insulating film 18 by using, for example, the reactive ion etching method. The via wirings 44 connected to the wirings 42 is formed in the through holes 50. The terminal electrodes 46 connected to the via wirings 44 are formed on the insulating film 18. The via wirings 44 and the terminal electrodes 46 are formed by using, for example, the sputtering method and the etching method. The via wirings 44 and the terminal electrodes 46 are formed of titanium nitride (TiN), for example. Thereafter, the bump electrodes 47 are formed on the terminal electrodes 46. The bump electrodes 47 are formed of, for example, indium (In). Thus, the device 100 according to the first embodiment is formed.

### [Comparative Example]

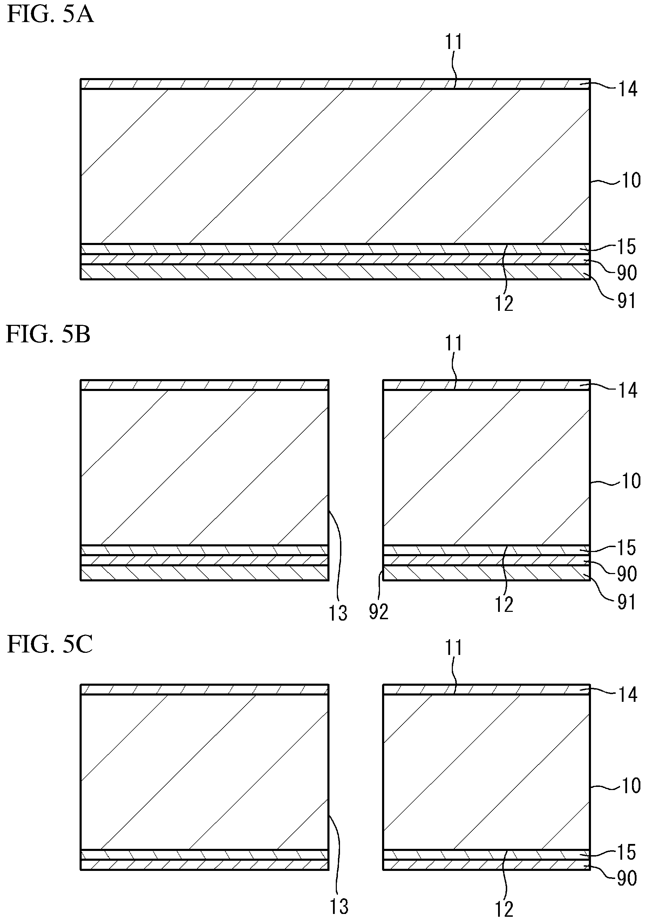

FIGs. 5A to 6C are cross-sectional views illustrating a method of manufacturing a device according to a comparative example. As illustrated in FIG. 5A, the substrate 10, which is a silicon substrate, is heated in an oxygen atmosphere to form the insulating film 14 and the insulating film 15 on the upper surface 11 and the lower surface 12. Thereafter, a conductive film 90 and a metal mask layer 91 are formed on the insulating film 15. The conductive film 90 is, for example, a gold (Au) film. The metal mask layer 91 is, for example, an aluminum (Al) layer. The conductive film 90 and the metal mask layer 91 are formed by, for example, the sputtering method or a vacuum deposition method.

As illustrated in FIG. 5B, the metal mask layer 91, the conductive film 90, and the insulating film 15 are etched using a resist mask layer (not illustrated) formed on the metal mask layer 91 as a mask to form an opening 92. Next, the substrate 10 is etched using the metal mask layer 91 as a mask to form the through hole 13 penetrating the substrate 10 from the lower surface 12 to the upper surface 11. Next, the insulating film 14 exposed on the bottom surface of the through hole 13 is removed by etching.

As illustrated in FIG. 5C, the metal mask layer 91 is removed by, for example, the wet etching method.

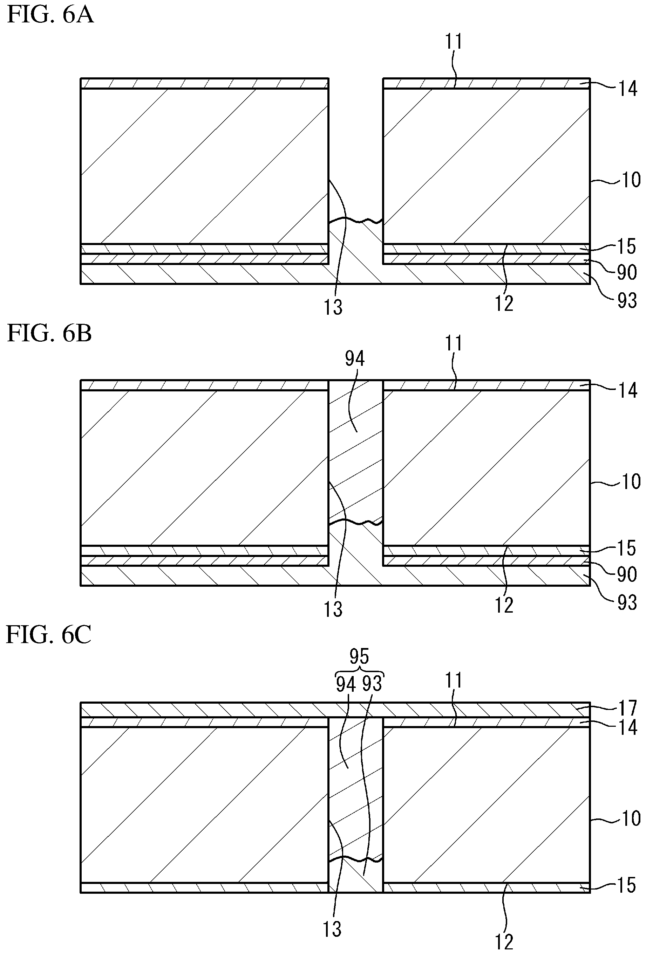

As illustrated in FIG. 6A, a non-superconducting film 93 is formed on the conductive film 90 by using the electroplating method. The non-superconducting film 93 is formed of, for example, copper (Cu). Since the through hole 13 is formed in the substrate 10, the non-superconducting film 93 may enter the through hole 13.

As illustrated in FIG. 6B, a superconducting film 94 is embedded in the through hole 13 by the electroplating method using the non-superconducting film 93 as the seed layer. The superconducting film 94 is formed of, for example, tin (Sn).

As illustrated in FIG. 6C, after the insulating film 17 is formed on the insulating film 14 so as to cover the upper surface of the superconducting film 94, the non-superconducting film 93 and the conductive film 90 formed on the insulating film 15 are removed by using, for example, the CMP method. Thus, a through electrode 95 including the non-superconducting film 93 and the superconducting film 94 is formed in the through hole 13. Thereafter, the same steps as steps illustrated in FIGs. 3B to 4B are performed.

In the comparative example, as illustrated in FIGS. 5B to 6A, after the through hole 13 is formed in the substrate 10, the non-superconducting film 93 is formed on the lower surface 12 of the substrate 10. Therefore, a part of the non-superconducting film 93 may enter the through hole 13. Therefore, when the superconducting film 94 is formed in the through hole 13 by the electroplating method using the non-superconducting film 93 as the seed layer as illustrated in FIGs. 6B and 6C, the through electrode 95 including the non-superconducting film 93 and the superconducting film 94 may be formed.

The non-superconducting film 93 does not exhibit superconductivity at a very low temperature (for example, 10K or less). Therefore, when the non-superconducting film 93 is included in the through electrode 95, the electrical resistance of the through electrode 95 increases even at a very low temperature, and the characteristics of the device may deteriorate.

According to the first embodiment, as illustrated in FIG. 2A, the conductive film 61 is formed on the lower surface 12 (second surface) of the substrate 10 using a non-superconducting material (e.g., Cu). As illustrated in FIG. 2B, after the conductive film 61 is formed, the substrate 10 is etched from the upper surface 11 (first surface) of the substrate 10 to form the through hole 13 penetrating the substrate 10 from the upper surface 11 to the lower surface 12. As illustrated in FIG. 2C, the through electrode 30 is formed in the through hole 13 by using the superconducting material (e.g., Sn) by the electroplating method using the conductive film 61 exposed in the through hole 13 as the seed layer. As illustrated in FIG. 3A, after the through electrode 30 is formed, the conductive film 61 is removed. This can suppress the non-superconducting material from being contained in the through electrode 30. Therefore, an increase in the electric resistance of the through electrode 30 at the very low temperature can be suppressed, and the deterioration of the characteristics of the device can be suppressed.

**In** the first embodiment, as illustrated in FIG. 3A, before the conductive film 61 is removed, the insulating film 17 covering the through electrode 30 is formed on the upper surface 11 of the substrate 10. This can suppress the through electrode 30 from being damaged in the removal of the conductive film 61.

In the first embodiment, as illustrated in FIG. 3B, the wiring 42 connected to the through electrode 30 is formed on the lower surface 12 of the substrate 10 using the superconducting material. As illustrated in FIG. 3C, the wiring 40 connected to the through electrode 30 is formed on the upper surface 11 of the substrate 10 using the superconducting material. Since the inclusion of the non-superconducting material in the through electrode 30 is suppressed, the increase in the electric resistance between the wiring 40 and the wiring 42 at the very low temperature is suppressed.

In the first embodiment, the conductive film 61 used as the seed layer is formed by containing copper (Cu) which is the non-superconducting material. Thus, the conductive film 61 having high electrical conductivity and low ionization tendency is obtained. That is, the conductive film 61 has a small electric resistance and is less likely to be eluted in a plating solution, and is suitable for use as the seed layer in the electroplating method. Further, since the conductive film 61 can be formed by the plating method and can be removed by the wet etching method or the CMP method, the conductive film 61 can be easily formed and removed. From this viewpoint, the conductive film 61 may be formed by containing gold (Au) or silver (Ag) which is a non-superconducting material, in addition to copper (Cu).

In the first embodiment, the through electrode 30 is formed by containing tin (Sn), but may be formed by containing other superconducting materials as long as the through electrode 30 can be formed by the electroplating method. For example, the through electrode 30 may be formed by containing tin (Sn), zinc (Zn), cadmium (Cd), lead (Pb), indium (In), or ruthenium (Ru).

### [Second Embodiment]

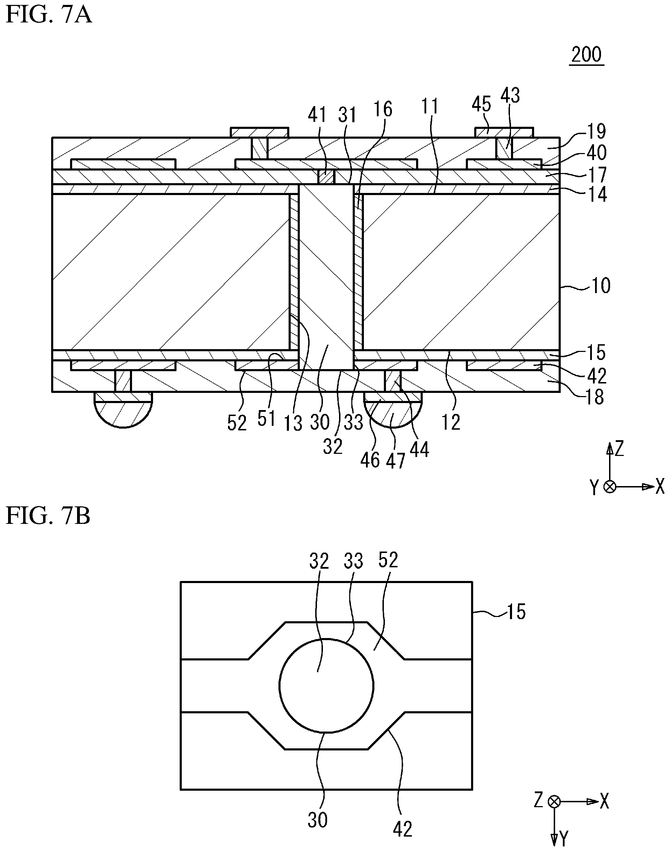

FIG. 7A is a cross-sectional view of a device 200 according to a second embodiment. FIG. 7B is a plan view of the vicinity of the through electrode 30 in the second embodiment, as viewed from the -Z direction. As illustrated in FIG. 7A, in the second embodiment, an insulating film 16 is provided on the side wall surface of the through hole 13. The insulating film 16 is, for example, a silicon oxide (SiO₂) film having a thickness of 50 nm to 100 nm. The through electrode 30 protrudes in the -Z direction from the lower surface of the insulating film 15. That is, the lower surface 32 of the through electrode 30 is positioned in the - Z direction with respect to the lower surface of the insulating film 15 and the upper surface 51 of the wiring 42. The lower surface 32 of the through electrode 30 is flush with a lower surface 52 of the wiring 42. The wiring 42 connected to the through electrode 30 is in contact with a side surface 33 of the through electrode 30. The other configuration is the same as that of the first embodiment, and therefore, the description thereof is omitted.

As illustrated in FIG. 7B, the lower surface 32 of the through electrode 30 has a circular planar shape. Although not illustrated, the upper surface 31 of the through electrode 30 also has a circular planar shape. The wiring 42 does not cover the lower surface 32 of the through electrode 30, but contacts the side surface 33 of the through electrode 30. The wiring 42 has a planar shape such as a hexagonal shape around the through electrode 30, for example. The upper surface 31 and the lower surface 32 of the through electrode 30 are not limited to the circular shape, and may be other planar shapes such as an elliptical shape. The shape of the wiring 42 around the through electrode 30 may be a planar shape such as a polygonal shape, a circular shape, or an elliptical shape.

### [Manufacturing Method]

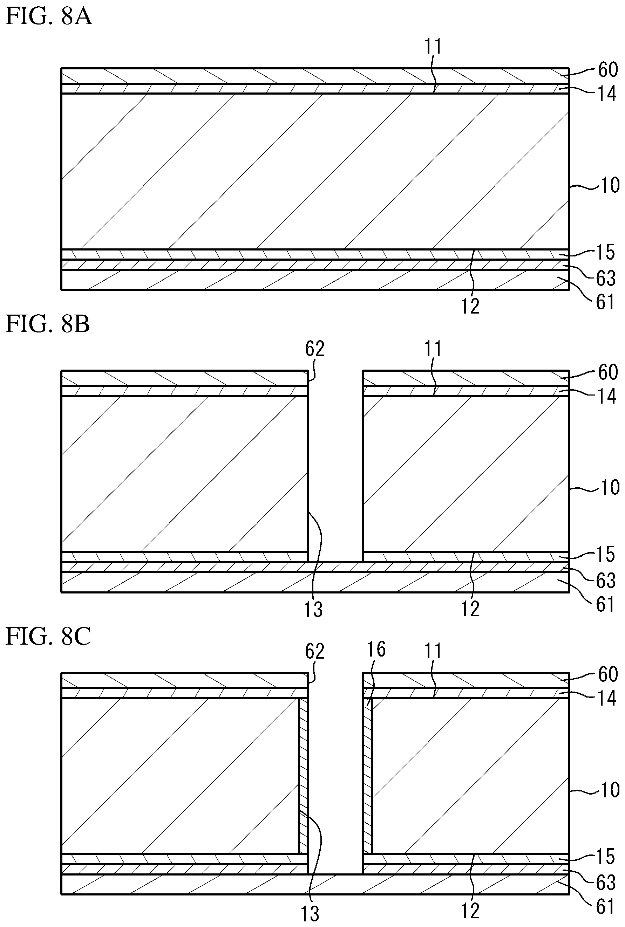

FIGs. 8A to 9C are cross-sectional views illustrating a method of manufacturing the device 200 according to the second embodiment. As illustrated in FIG. 8A, the substrate 10 which is a silicon substrate, for example, is heated in an oxygen atmosphere to form the insulating film 14 and the insulating film 15 on the upper surface 11 and the lower surface 12. Next, the metal mask layer 60 is formed on the insulating film 14. A superconducting film 63 and the conductive film 61 are formed on the insulating film 15 in this order. The superconducting film 63 is, for example, a titanium nitride (TiN) film and is formed by the sputtering method. The thickness of the superconducting film 63 is, for example, 100 nm.

As illustrated in FIG. 8B, the metal mask layer 60 and the insulating film 14 are etched using a resist mask layer (not illustrated) formed on the metal mask layer 60 as a mask, and the opening 62 is formed in the metal mask layer 60 and the insulating film 14. Next, the substrate 10 is etched using the metal mask layer 60 as the mask, and the through hole 13 penetrating the substrate 10 from the upper surface 11 to the lower surface 12 is formed. The insulating film 15 located on the bottom surface of the through hole 13 is removed by using, for example, the reactive ion etching method.

As illustrated in FIG. 8C, the substrate 10 is heated in an oxygen atmosphere to form the insulating film 16 on the side wall surface of the through hole 13. Then, the superconducting film 63 located on the bottom surface of the through hole 13 is removed by using, for example, the reactive ion etching method. As a result, the conductive film 61 is exposed in the through hole 13.

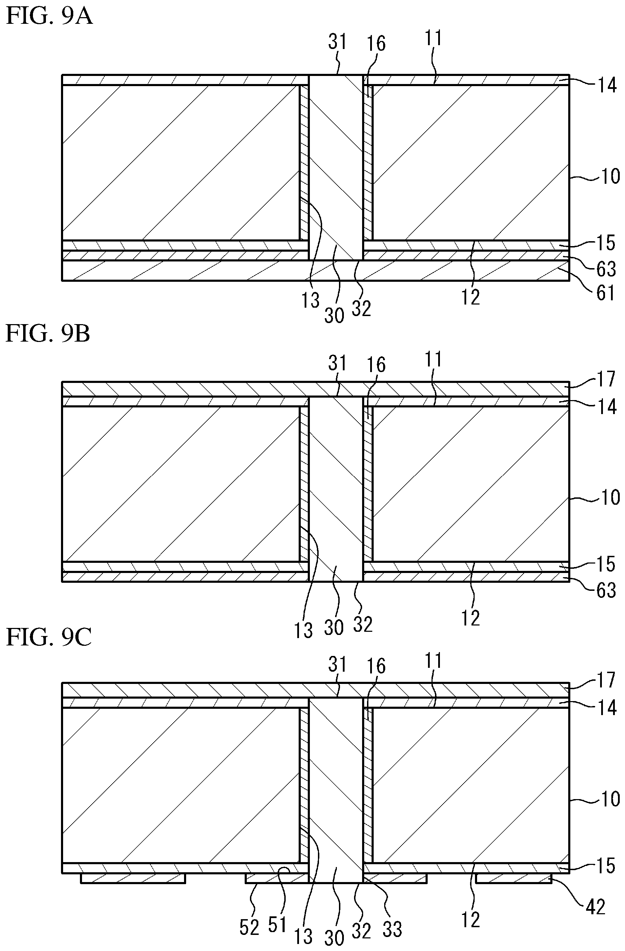

As illustrated in FIG. 9A, after the metal mask layer 60 is removed, the superconducting film is embedded in the through hole 13 by the electroplating method using the conductive film 61 as the seed layer, and the through electrode 30 made of the superconducting film is formed.

As illustrated in FIG. 9B, the insulating film 17 is formed on the insulating film 14 so as to cover the upper surface 31 of the through electrode 30. Then, the conductive film 61 is removed by the wet etching method or the CMP method. When the superconducting film 63 is a TiN film, the superconducting film 63 is less likely to dissolved in an etching solution for the conductive film 61 which is a Cu film, and is harder than the conductive film 61. Therefore, when the conductive film 61 is removed by the wet etching method or the CMP method, the superconducting film 63 can be used as a stopper layer. The lower surface 32 of the through electrode 30 and the lower surface of the superconducting film 63 are flush with each other. In this way, from the viewpoint of making the superconducting film 63 function as the stopper layer when the conductive film 61 is removed, it is preferable that the superconducting film 63 is formed of a hard superconducting material which is difficult to dissolve in the etching solution. For example, the superconducting film 63 is preferably formed of titanium nitride (TiN), vanadium (V), niobium (Nb), tantalum (Ta), vanadium nitride (VN), niobium nitride (NbN), or tantalum nitride (TaN).

As illustrated in FIG. 9C, the superconducting film 63 is patterned by, for example, the reactive ion etching method, thereby forming the wirings 42 on the insulating film 15. The wirings 42 are formed of a superconducting material different from that of the through electrode 30. At least a part of the wirings 42 is connected to the through electrode 30 by being in contact with the side surface 33 of the through electrode 30. The lower surface 32 of the through electrode 30 is located farther from the substrate 10 than an upper surface 51 of the wiring 42 and is flush with the lower surface 52 of the wiring 42. Thereafter, the same steps as those illustrated in FIGs. 3C to 4B of the first embodiment are performed. Thus, the device 200 according to the second embodiment is formed.

According to the second embodiment, as illustrated in FIG. 8A, before forming the conductive film 61, the superconducting film 63 (first superconducting film) is formed on the lower surface 12 of the substrate 10. The conductive film 61 is formed on the superconducting film 63. As a result, as illustrated in FIG. 9B, the superconducting film 63 can be used as the stopper layer when the conductive film 61 is removed. Therefore, the ease of manufacture can be improved. From the viewpoint of using the superconducting film 63 as the stopper layer, the superconducting film 63 is preferably formed by containing TiN, V, Nb, Ta, VN, NbN, or TaN.

In the second embodiment, as illustrated in FIGs. 9B and 9C, after the conductive film 61 is removed, the superconducting film 63 (first superconducting film) is patterned to form the wiring 42 connected to the through electrode 30. Thus, since the wirings 42 are formed by using the superconducting film 63 which can be used as the stopper layer when the conductive film 61 is removed, the manufacturing simplicity can be improved. In this case, as illustrated in FIG. 7A, the through electrode 30 protrudes in the -Z direction from the lower surface 12 (second surface) of the substrate 10. The wiring 42 formed of a superconducting material different from the superconducting material of the through electrode 30 is in contact with the side surface 33 of the through electrode 30. The lower surface 32 of the through electrode 30 (the tip surface protruding from the lower surface 12 of the substrate 10) is flush with the lower surface 52 of the wiring 42 (the surface opposite to the lower surface 12 of the substrate 10).

### [Third Embodiment]

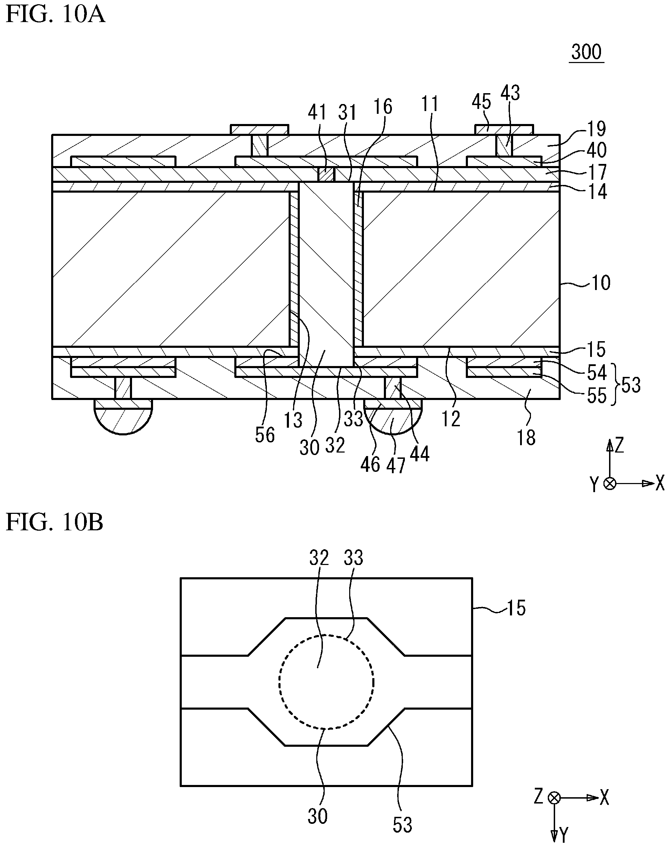

FIG. 10A is a cross-sectional view of a device 300 according to a third embodiment. FIG. 10B is a plan view of the vicinity of the through electrode 30 in the third embodiment, as viewed from the -Z direction. As illustrated in FIG. 10A, in the third embodiment, the insulating film 16 is provided on the side wall surface of the through hole 13. Wirings 53 are provided on the insulating film 15. The wirings 53 are formed of a superconducting material. The wirings 53 are formed of, for example, titanium nitride (TiN), vanadium (V), niobium (Nb), tantalum (Ta), vanadium nitride (VN), niobium nitride (NbN), or tantalum nitride (TaN). The thicknesses of the wirings 53 are, for example, 100 nm to 300 nm. At least a part of the wirings 53 is in contact with the side surface 33 and the lower surface 32 of the through electrode 30 projected in the -Z direction from the lower surface of the insulating film 15, and covers the through electrode 30. The wiring 53 includes a first layer 54 and a second layer 55. The wiring 53 is connected to the through electrode 30 by the first layer 54 being in contact with the side surface 33 of the through electrode 30 and the second layer 55 being in contact with the lower surface 32 of the through electrode 30. Therefore, the lower surface 32 of the through electrode 30 is located in the -Z direction with respect to the lower surface of the insulating film 15 and an upper surface 56 of the wiring 53. The other configuration of the third embodiment is the same as that of the first embodiment, and therefore, the description thereof is omitted.

As illustrated in FIG. 10B, in the third embodiment, similarly to the second embodiment, the lower surface 32 of the through electrode 30 has a circular planar shape, and the wiring 53 has a planar shape such as a hexagonal shape around the through electrode 30. The lower surface 32 of the through electrode 30 may have another planar shape such as an elliptical shape. The wiring 53 may have a planar shape such as a polygonal shape, a circular shape, or an elliptical shape.

### [Manufacturing Method]

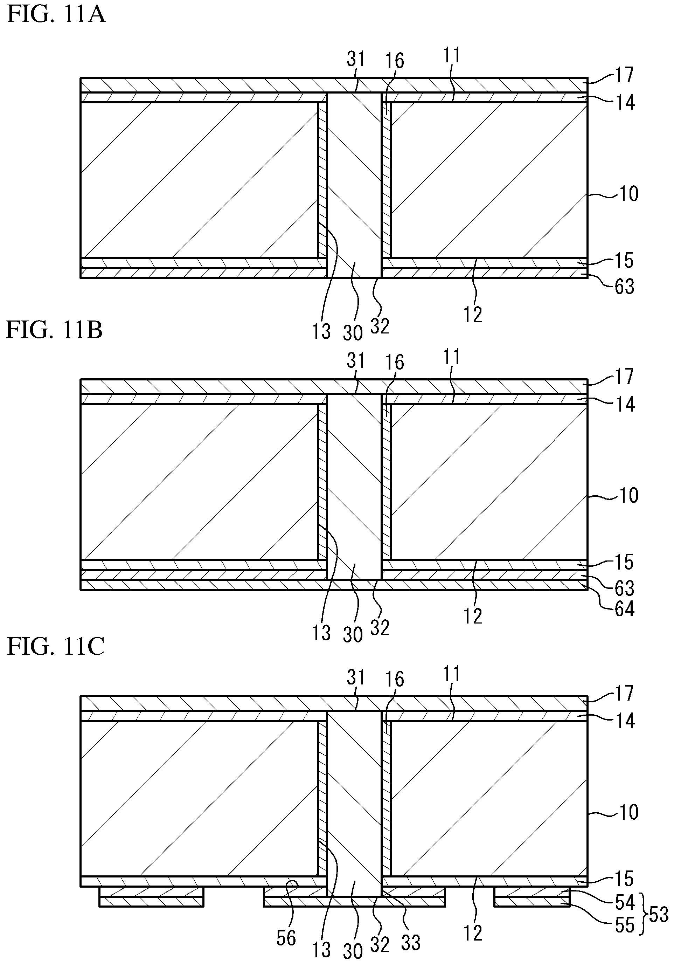

FIGs. 11A to 11C are cross-sectional views illustrating a method of manufacturing the device 300 according to the third embodiment. As illustrated in FIG. 11A, the steps illustrated in FIGs. 8A to 9B of the second embodiment are first performed.

As illustrated in FIG. 11B, a superconducting film 64 is formed on the superconducting film 63 so as to cover the through electrode 30. The superconducting film 64 is, for example, a titanium nitride (TiN) film and is formed by sputtering. The thickness of the superconducting film 64 is, for example, 100 nm.

As illustrated in FIG. 11C, the superconducting films 63 and 64 are patterned by, for example, the reactive ion etching method, thereby forming the wirings 53 including the first layer 54 and the second layer 55 on the insulating film 15. The wirings 53 are formed of a superconducting material different from that of the through electrode 30. At least a part of the wirings 53 is formed so as to cover the through electrode 30 protruding from the lower surface 12 of the substrate 10. That is, the first layer 54 is in contact with the side surface 33 of the through electrode 30 and the second layer 55 is in contact with the lower surface 32 of the through electrode 30, so that the wiring 53 is connected to the through electrode 30. The lower surface 32 of the through electrode 30 is located further from the lower surface 12 of the substrate 10 than the upper surface 56 of the wiring 53. Thereafter, the same steps as those illustrated in FIGs. 3C to 4B of the first embodiment are performed. Thus, the device 300 according to the third embodiment is formed.

According to the third embodiment, as illustrated in FIG. 11A, the superconducting film 63 (first superconducting film) is formed on the lower surface 12 of the substrate 10 before the conductive film 61 is formed (see also FIG. 8A of the second embodiment). As illustrated in FIG. 11B, after the conductive film 61 is removed, the superconducting film 64 (second superconducting film) is formed on the superconducting film 63 so as to cover the through electrode 30. As illustrated in FIG. 11C, the superconducting film 63 and the superconducting film 64 are patterned to form the wiring 53 connected to the through electrode 30. This increases a contact area between the through electrode 30 and the wiring 53, and thus the connection reliability between the through electrode 30 and the wiring 53 can be improved. In this case, as illustrated in FIG. 10A, the through electrode 30 protrudes in the -Z direction from the lower surface 12 (second surface) of the substrate 10. The wiring 53 formed of a superconducting material different from that of the through electrode 30 is in contact with the side surface 33 and the lower surface 32 (the tip surface protruding from the lower surface 12 of the substrate 10) of the through electrode 30.

### [Fourth Embodiment]

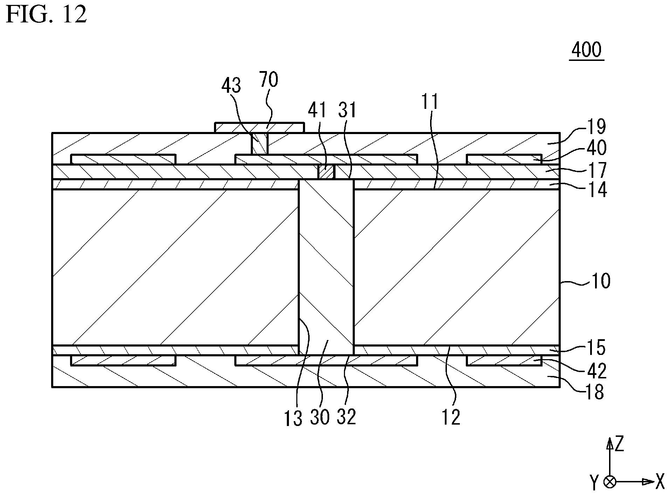

FIG. 12 is a cross-sectional view of a device 400 according to a fourth embodiment. As illustrated in FIG. 12, in the fourth embodiment, the via wirings 44, the terminal electrodes 45, the terminal electrodes 46, and the bump electrodes 47 are not provided, as compared with the first embodiment illustrated in FIG. 1. Instead, a qubit 70 is provided on the insulating film 19. The qubit 70 is connected to the wiring 40 through the via wiring 43. The qubit 70 is an element that forms a coherent two level system using superconductivity. For example, the qubit 70 includes a transmon qubit circuit in which a Josephson element and a capacitor are connected in parallel. The other configuration of the fourth embodiment is the same as that of the first embodiment, and therefore, the description thereof is omitted.

### [Manufacturing Method]

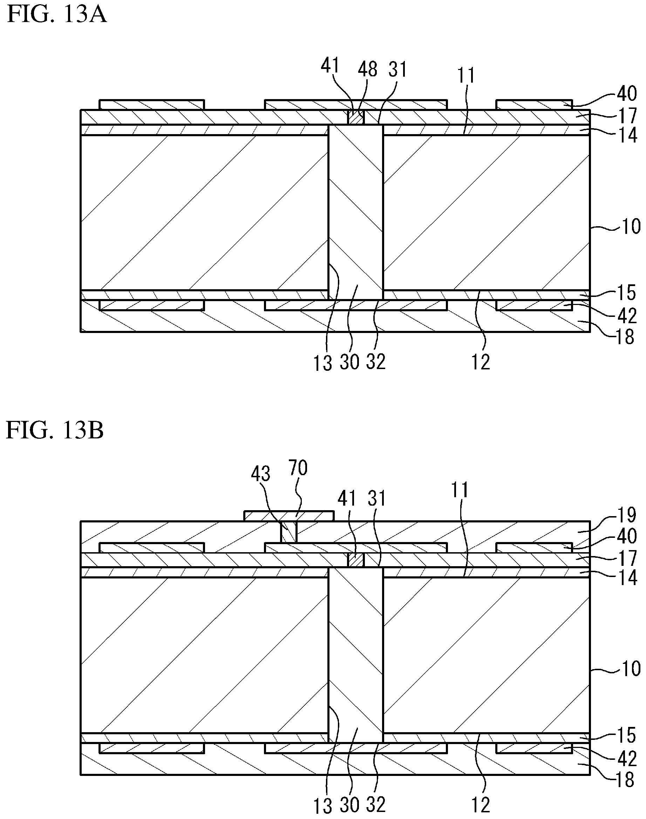

FIGs. 13A and 13B are cross-sectional views illustrating a method of manufacturing the device 400 according to a fourth embodiment. As illustrated in FIG. 13A, the steps illustrated in FIGs. 2A to 3C of the first embodiment are first performed.

As illustrated in FIG. 13B, the insulating film 19 is formed on the insulating film 17 so as to cover the wiring 40. Then, the via wiring 43 is formed in the insulating film 19. Next, the qubit 70 connected to the via wiring 43 is formed on the insulating film 19. When the qubit 70 includes the Josephson element, the qubit 70 is formed by a generally known method using, for example, an oblique vacuum deposition method. Thus, the device 400 according to the fourth embodiment is formed.

### [Modification]

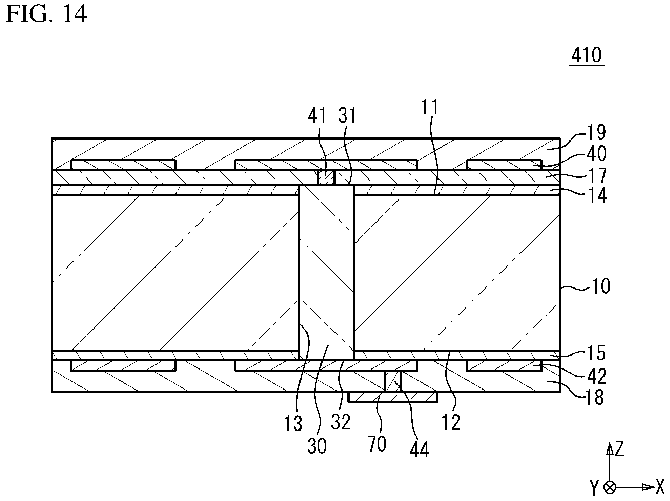

FIG. 14 is a cross-sectional view of a device 410 according to a modification of the fourth embodiment. As illustrated in FIG. 14, in the modification of the fourth embodiment, the qubit 70 is not provided on the insulating film 19, but is instead provided on the insulating film 18 to be connected to the wiring 42 through the via wiring 44. The other configuration of the modification of the fourth embodiment is the same as that of the fourth embodiment, and therefore, the description thereof is omitted. The device 410 according to the modification of the fourth embodiment is obtained by forming the via wiring 44 in the insulating film 18 and then forming the qubit 70 connected to the via wiring 44 on the insulating film 18.

According to the fourth embodiment and the modification thereof, after the same steps as those in the first embodiment illustrated in FIGs. 2A to 3C are performed, the qubit 70 connected to the through electrode 30 is formed on the upper surface 11 or the lower surface 12 of the substrate 10. Since the inclusion of the non-superconducting material in the through electrode 30 is suppressed, the deterioration of the characteristics of the device including the qubit 70 can be suppressed.

### [Fifth Embodiment]

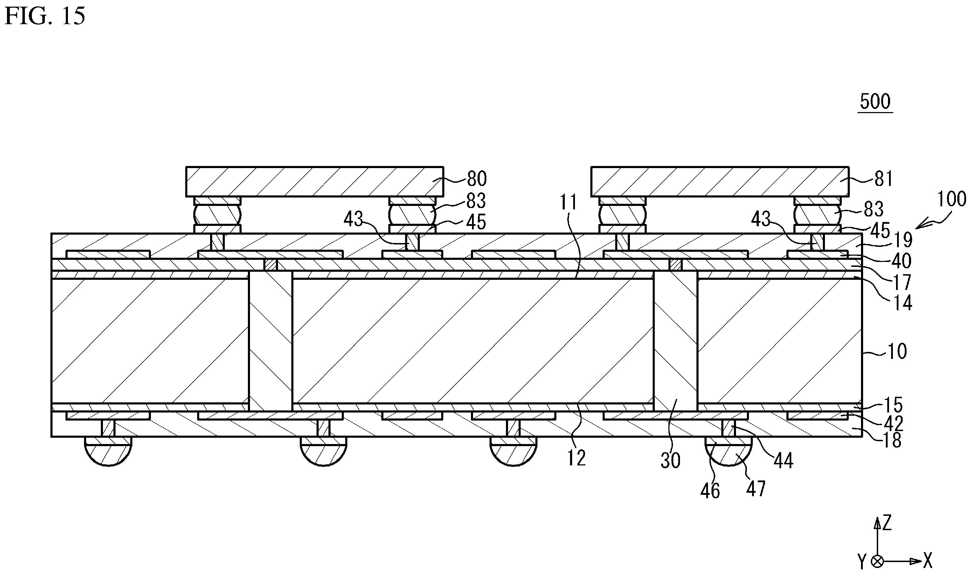

FIG. 15 is a cross-sectional view of a device 500 according to a fifth embodiment. As illustrated in FIG. 15, in the fifth embodiment, a chip 80 and a chip 81 are flip-chip mounted on the upper surface 11 of the substrate 10 of the device 100 of the first embodiment by bump electrodes 83. At least one of the chips 80 and 81 is a quantum chip having a qubit. For example, both of the chips 80 and 81 may be quantum chips, or one of the chips may be a quantum chip and the other thereof may be a control chip. In the chips 80 and 81, a device surface on which a circuit such as a qubit is formed may be a surface facing the substrate 10 side or may be a surface opposite to the substrate 10.

The device 500 according to the fifth embodiment is formed by carrying out the steps of the first embodiment illustrated in FIGs. 2A to 4B and then flip-chip mounting the chips 80 and 81 on the upper surface 11 of the substrate 10.

### [Modification]

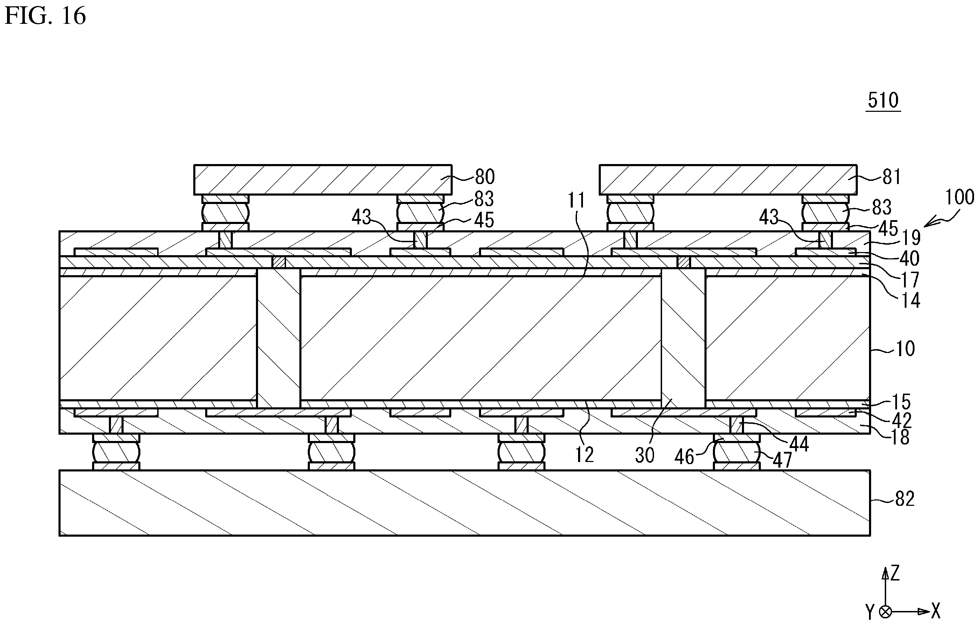

FIG. 16 is a cross-sectional view of a device 510 according to a modification of the fifth embodiment. As illustrated in FIG. 16, in the modification of the fifth embodiment, in addition to the chips 80 and 81 being flip-chip mounted on the upper surface 11 of the substrate 10, a chip 82 is flip-chip mounted on the lower surface 12 of the substrate 10 by the bump electrodes 47. For example, the chips 80 and 81 are quantum chips and the chip 82 is a control chip. Other cases may be used as long as at least one of the chips 80 to 82 is a quantum chip.

In the device 510 according to the modification of the fifth embodiment, after the steps of the first embodiment illustrated in FIGs. 2A to 4B are performed, the chips 80 and 81 are flip-chip mounted on the upper surface 11 of the substrate 10. The chip 82 is flip-chip mounted on the lower surface 12 of the substrate 10. The device 510 is formed by performing such a process.

According to the fifth embodiment and the modification thereof, after the same steps as those illustrated in FIGs. 2A to 4B of the first embodiment are performed, one or the plurality of chips 80 to 82 are mounted on at least one of the upper surface 11 and the lower surface 12 of the substrate 10. At least one of the chips 80 to 82 is a quantum chip. Since the inclusion of the non-superconducting material in the through electrode 30 is suppressed, the deterioration of the characteristics of the device including the quantum chip can be suppressed.

Although the embodiment of the present invention is described in detail, the present invention is not limited to the specifically described embodiments and variations but other embodiments and variations may be made without departing from the scope of the claimed invention.

## Claims

1. A method of manufacturing a device (100, 200, 300, 400, 410, 500, 510) comprising:
forming a conductive film (61) on a second surface (12) of a substrate (10) having a first surface (11) and the second surface opposite to the first surface by using a non-superconducting material;
forming a through hole (13) penetrating the substrate by etching the substrate from the first surface after forming the conductive film;
forming a through electrode (30) in the through hole by using a superconducting material by an electroplating method using the conductive film exposed in the through hole as a seed layer; and
removing the conductive film after forming the through electrode.

2. The method of manufacturing the device according to claim 1, further comprising:
forming a first superconducting film (63) on the second surface before forming the conductive film,
wherein the forming the conductive film forms the conductive film on the first superconducting film.

3. The method of manufacturing the device according to claim 2, further comprising:
forming a wiring (42) connected to the through electrode by patterning the first superconducting film after removing the conductive film.

4. The method of manufacturing the device according to claim 2, further comprising:
forming a second superconducting film (64) on the first superconducting film to cover the through electrode after removing the conductive film; and
forming a wiring (53) connected to the through electrode by patterning the first superconducting film and the second superconducting film.

5. The method of manufacturing the device according to any preceding claim, further comprising:
forming an insulating film (17) covering the through electrode on the first surface before removing the conductive film.

6. The method of manufacturing the device according to claim **1,** further comprising:
forming a first wiring (42) connected to the through electrode on the second surface by using a superconducting material; and
forming a second wiring (40) connected to the through electrode on the first surface by using a superconducting material.

7. The method of manufacturing the device according to any preceding claim **1,** further comprising:
forming a qubit (70) connected to the through electrode on the first surface or the second surface.

8. The method of manufacturing the device according to any preceding claim **1,** further comprising:
mounting one or a plurality of chips (80 to 82) on at least one of the first surface and the second surface,
wherein at least one of the one or the plurality of chips is a quantum chip.

9. The method of manufacturing the device according to any preceding claim, wherein
the conductive film contains copper, gold, or silver.

10. The method of manufacturing the device according to any preceding claim, wherein
the through electrode contains tin, zinc, cadmium, lead, indium, or ruthenium.

11. The method of manufacturing the device according to claim 2, wherein
the first superconducting film contains titanium nitride, vanadium, niobium, tantalum, vanadium nitride, niobium nitride, or tantalum nitride.

12. A device (100, 200, 300, 400, 410, 500, 510) comprising:
a substrate (10) having a first surface (11) and a second surface (12) opposite to the first surface;
a through electrode (30) that penetrates the substrate from the first surface to the second surface, the through electrode being formed of a superconducting material; and
a wiring (42, 53) provided on the second surface so as to be connected to the through electrode, the wiring being formed of a superconducting material different from the through electrode,
wherein the through electrode protrudes from the second surface and the wiring is in contact with at least a side surface (33) of the through electrode.

13. The device according to claim 12, wherein
a tip surface (32) of the through electrode protruding from the second surface is flush with a surface (52) of the wiring opposite to the second surface.

14. The device according to claim 12 or 13, wherein
the wiring is in contact with the side surface of the through electrode and a tip surface (32) of the through electrode protruding from the second surface.
